(19) Europäisches Patentamt
European Patent Office
Office européen des brevets

(11) **EP 4 753 408 A1**

(12) **DEMANDE DE BREVET EUROPEEN**

(43) Date de publication:
**03.06.2026 Bulletin 2026/23**

(21) Numéro de dépôt: **25218431.2**

(22) Date de dépôt: **25.11.2025**

(51) Classification Internationale des Brevets (IPC):
**H10F 71/10** (2025.01)     **H10F 71/00** (2025.01)

(52) Classification Coopérative des Brevets (CPC):
**H10F 71/103; H10F 71/128; H10F 71/132**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **28.11.2024 FR 2413105**

(71) Demandeur: **Commissariat à l'Energie Atomique et aux Energies Alternatives**
**75015 Paris (FR)**

(72) Inventeurs:
• **PIHAN, Etienne**
**38054 GRENOBLE CEDEX 09 (FR)**
• **ALBARIC, Mickaël**
**38054 GRENOBLE CEDEX 09 (FR)**
• **ENJALBERT, Nicolas**
**38054 GRENOBLE CEDEX 09 (FR)**
• **DUBOIS, Sébastien**
**38054 GRENOBLE CEDEX 09 (FR)**

(74) Mandataire: **Atout PI Laplace**
**Immeuble Up On**
**25 Boulevard Romain Rolland**
**CS 40072**
**75685 Paris Cedex 14 (FR)**

(54) **PROCÉDÉ DE TRAITEMENT D'UNE PLAQUETTE DE SILICIUM CRISTALLIN UTILISÉE EN PHOTOVOLTAÏQUE**

(57)     L'invention concerne un procédé de traitement d'une plaquette de silicium cristallin conduisant à une réduction de la densité de défauts Bore-Oxygène qui augmentent la sensibilité à l'illumination, qui comprend une étape i) de chauffage de la plaquette de silicium cristallin à une température appartenant à la gamme allant de 650°C à 1200°C, où l'étape i) est suivie d'une étape ii) de refroidissement ultra-rapide qui démarre alors que la plaquette de silicium cristallin est encore à une température de 600°C au moins, et, lors de laquelle, la température de la plaquette de silicium cristallin est abaissée selon une vitesse de refroidissement de 150 à 2000 °C/s, jusqu'à atteindre une température de 400°C ou moins. L'invention concerne également les plaquettes de silicium cristallin, les procédés de fabrication d'une cellule photovoltaïque et les cellules photovoltaïques correspondants.

[Fig. 1]

EP 4 753 408 A1

**Description**

Domaine technique

La présente invention est relative au domaine technique photovoltaïque. Plus précisément, elle concerne un procédé de traitement de plaquettes de silicium cristallin utilisées pour la fabrication de cellules photovoltaïques. Elle a également pour objet des procédés de préparation de cellules photovoltaïques, ainsi que les plaquettes de silicium et cellules photovoltaïques susceptibles d'être obtenues par de tels procédés.

Arrière-plan technologique de l'invention et problème technique

Les cellules photovoltaïques, composants de base des modules photovoltaïques, sont des dispositifs électroniques qui convertissent la lumière du soleil en électricité. Le principe photovoltaïque consiste en la transformation de l'énergie solaire, par captation des photons, en énergie électrique, se traduisant par un déplacement de porteurs de charge positive et de porteurs de charge négative dans la cellule photovoltaïque. Les cellules photovoltaïques sont fabriquées à partir de semi-conducteurs tels que le silicium et elles génèrent un courant électrique continu en réponse à un rayon lumineux incident. Aujourd'hui, les technologies utilisant des plaquettes de silicium cristallin (monocristallin sc-Si ou multicristallin mc-Si) sont les plus utilisées. Dans les cellules photovoltaïques, le silicium cristallin peut se trouver sur une forme dite silicium de type p, dans laquelle la majorité des porteurs de charge sont des trous d'électrons, ou bien sous une forme dite silicium de type n, dans laquelle la majorité des porteurs de charge sont des électrons libres. Le silicium de type p est généralement dopé avec du bore (B), mais d'autres dopants du groupe 13 du tableau périodique des éléments tels que l'aluminium (Al) ou le Gallium (Ga) peuvent également être utilisés à la place ou en complément du bore. Le silicium de type n est généralement dopé avec un élément du groupe 15 du tableau périodique des éléments, typiquement du phosphore (P) ou de l'Arsenic (As).

Il est connu que le silicium cristallin utilisé dans les cellules photovoltaïques contient souvent de l'oxygène, en particulier de l'oxygène dit interstitiel ($O_i$), situé dans des positions interstitielles du réseau cristallin du silicium. La présence de l'oxygène interstitiel peut avoir plusieurs origines. Une méthode courante de fabrication du silicium cristallin est le procédé Czochralski, conduisant à un silicium nommé silicium Czochralski (Si Cz). Dans ce procédé, un cristal de silicium est tiré à partir d'un creuset en silice fondu ($SiO_2$) et le silicium cristallin obtenu contient nécessairement de l'oxygène provenant du creuset. Le silicium cristallin peut être obtenu par d'autres procédés tels que la méthode Bridgman, plus connue sous le nom de solidification dirigée (en anglais « directional solidification »), ou la technique de cristallisation en zone (en anglais « float zone », donnant du FZ Si), bien que cette technique conduise à un silicium cristallin de haute pureté avec une quantité moindre d'oxygène interstitiel. L'oxygène interstitiel peut également être présent en tant que contaminant, notamment dans des substrats silicium de plus faible pureté.

Il a été décrit dans la littérature (S.W. Glunz *et al.*, 2001, notamment) que les atomes d'oxygène se combinaient avec le bore présent dans les plaquettes de silicium cristallin, notamment du type Si Cz, pour former des défauts, nommés défauts « Bore-Oxygène », bien que la stœchiométrie exacte ne soit pas connue, qui sous l'action de la lumière induisaient une diminution de la durée de vie des porteurs de charge et augmentaient la sensibilité à la lumière (LID : de l'anglais « light-induced degradation ») des plaquettes de silicium. La nature et la stœchiométrie des défauts induisant la LID ne sont pas parfaitement connues. Plusieurs hypothèses sont avancées dans la littérature, comme par exemple des complexes dans lesquels le bore est associé avec des dimères d'oxygène interstitiel. La LID se caractérise par une dégradation de la durée de vie (DDV) des porteurs de charge de la plaquette de silicium en question et par une dégradation des propriétés photovoltaïques de la cellule correspondante, lors de l'exposition à la lumière (de façon plus générale lorsque des porteurs sont injectés dans le dispositif). Ce problème existe que le bore soit présent en tant qu'agent dopant principal (silicium de type p), en tant qu'agent dopant secondaire (silicium de type p dans lequel le bore est un dopant additionnel à Al ou Ga, silicium de type n dans lequel le bore est un dopant additionnel au phosphore ou à l'antimoine, ce type de silicium étant nommé silicium de type n compensé ou en tant que contaminant dans des siliciums de moindre pureté (par exemple, silicium cristallin obtenu à partir de silicium recyclé ou de silicium UMG : silicium de grade solaire qui contient du bore). Traditionnellement, les lingots de Si Cz utilisés pour obtenir des plaquettes de Si Cz sont obtenus à partir d'un silicium de haute pureté. Dans ce cas le Si Cz contient peu d'atomes de bore, en tant que contaminant. Mais, il est également possible de réaliser le procédé Czochralski, en incorporant une partie de silicium UMG ou recyclé au silicium de haute pureté traditionnellement utilisé. Le silicium UMG est obtenu par purification par voie métallurgique (le silicium reste à l'état solide ou liquide) du silicium métallurgique, tandis que le silicium recyclé provient de déchets de l'industrie photovoltaïque ou électronique. Dans un tel cas, le silicium cristallin obtenu contient du bore (notamment jusqu'à $5.10^{17}$ atomes/$cm^3$, unité également désignée $cm^{-3}$).

Les cellules photovoltaïques à hétérojonction (SHJ) utilisent majoritairement des plaquettes de silicium cristallin de type n qui peuvent parfois inclure des quantités de bore et d'oxygène formant des défauts Bore-Oxygène ». Ces défauts entrainent une forte sensibilité à l'illumination (LID) et après éclairement prolongé, une faible durée de vie des porteurs de charge de ces plaquettes, ce qui les rend peu attractives. La production des SHJ implique plusieurs étapes clés, chacune étant cruciale pour garantir l'efficacité et la durabilité des cellules. En général, des couches de silicium amorphe (de type p sur une face et de type n sur l'autre face) sont déposées sur une plaquette de silicium cristallin de type n. En plus, souvent, une couche de silicium amorphe intrinsèque intermédiaire contenant de l'hydrogène est déposée avant le dépôt des couches de silicium amorphes de type p et de type n. Actuellement, les couches de silicium amorphe dopé ont tendance à être remplacées par des couches de silicium nanocristallin (voire des empilements silicium amorphe, silicium nanocristallin). Ensuite, une couche transparente conductrice (typiquement en oxyde d'indium-étain ou en oxyde de zinc) est déposée sur chaque couche amorphe. Puis, des contacts métalliques, du type grille métallique, sont déposés sur la couche transparente conductrice (Les défis du CEA, février 2019, N°234). Un recuit (traitement thermique) est ensuite, mené pour améliorer les contacts. Une étape d'exposition à la lumière (dite « light soaking » en anglais) est, également, généralement réalisée après fabrication d'une cellule photovoltaïque. Cette étape consistant à exposer la cellule à une lumière intense (souvent fournie par des lampes halogènes ou des LED spéciales), pendant une période prolongée (allant de quelques heures à plusieurs jours, en fonction des spécifications et des exigences de performance de la cellule) a pour but de stabiliser et améliorer les performances de la cellule. Pendant cette étape, la température est contrôlée, de sorte qu'elle reste inférieure à 250°C. Lors de cette étape d'exposition à la lumière, le rendement photovoltaïque peut fortement être impacté, en raison de la LID due à la présence de défauts Bore-Oxygène.

La LID est donc associée à la présence de ces défauts Bore-Oxygène. La LID est diagnostiquée par une dégradation des propriétés photovoltaïques de la cellule ou par une dégradation de la durée de vie des porteurs de charge de la plaquette de silicium cristallin lors de l'exposition à la lumière (Z.Y. Yeo et al., 2014). Un traitement dit de régénération induit par la lumière (en anglais « light induced regeneration ») a été proposé pour limiter, voire pour neutraliser, les effets LID. Cela consistait à illuminer fortement ou à injecter un courant dans des cellules portées à température modérée (120-250°C).

Plusieurs autres stratégies ont également été proposées dans la littérature pour tenter de limiter les défauts Bore-Oxygène entrainant la LID, en appliquant un traitement thermique.

Dans S.W. Glunz et al.,J. Appl. Phys. 2001, des stratégies visant à réduire ou supprimer la LID dans du Si Cz de type p dopé au bore ont été étudiées. Différentes voies ont été proposées en vue de diminuer la densité de défauts Bore-Oxygène : la réduction de la concentration d'oxygène, la substitution ou réduction du bore, l'utilisation de traitements à haute température. En particulier, ont été proposés : soit un recuit combiné ou non à une oxydation en four conventionnel à tube à 750°C ou à 1050°C, soit un recuit à 850°C en four à lampes infrarouge à passage pendant 120 s (secondes) avec une couche barrière en nitrure de silicium ou en oxyde de silicium. Lorsque ces traitements thermiques ont été appliqués, simultanément une réduction de la qualité du silicium a pu se produire. Il est donc conclu dans cette publication que les procédés de traitement thermique doivent être optimisés soit pour limiter la contamination (par l'utilisation de couche barrière) soit pour limiter la précipitation de l'oxygène (par limitation du temps de traitement à haute température). Lorsque des indications sur les concentrations en défauts Bore-Oxygène sont reportées, sous la forme d'une valeur N*, grandeur proportionnelle à la densité de défauts, les concentrations après traitement sont de l'ordre de 25 à 65% des concentrations avant-traitement.

Par ailleurs, L.J. Caballero et al., 2005 ont montré une réduction de la densité de défauts Bore-Oxygène à environ 80%, 50% et 80% après une étape de traitement thermique à 875°C pendant 40 minutes correspondant, respectivement, à un procédé de diffusion phosphore (chauffage sous $POCl_3$), une oxydation sèche et un recuit en ambiance azote.

F. E. Rougieux et al., 2011, quant à eux, ont examiné la densité de défauts Bore-Oxygène dans le silicium de type n compensé (co-dopage bore-phosphore), en utilisant des mesures de durée de vie des porteurs. L'effet des recuits à une température intermédiaire (500°C à 700°C) sur la densité des défauts Bore-Oxygène a également été exploré. Dans cette publication, la densité des défauts Bore-Oxygène est présentée comme efficacement améliorée grâce à un recuit à ces températures, probablement en raison de la dissociation des dimères d'oxygène. Ainsi, la concentration de dimères d'oxygène disponibles pour interagir avec les atomes de bore est diminuée, ce qui réduit la densité des défauts Bore-Oxygène (ces explications reposent sur l'hypothèse que le défaut Bore-Oxygène est de la forme B-$O_{i2}$). Les auteurs ont déterminé une énergie d'activation pour ce processus de 0,14 eV, ce qui est relativement faible et ont suggéré que la plage de température de 500°C à 700°C était favorable à sa mise en œuvre.

Plus récemment, N. Nampalli et al., 2017 ont défini un modèle à quatre états pour les défauts Bore-Oxygène : l'état A qui est l'état recuit, inactif en termes de recombinaison possible (c'est à dire, pas d'effet sur la durée de vie des porteurs de charge), l'état B qui est un état dégradé qui est actif en termes de recombinaison possible, l'état C qui est un état régénéré ou passivé qui est également inactif en termes de recombinaison, mais contrairement à l'état A, l'état C est relativement stable et ne montre pas de dégradation supplémentaire lors de l'injection de porteurs de charge. En plus de ces trois états déjà connus, les auteurs introduisent un état D, qualifié d'état dissocié, également inactif en termes de recombinaison, pour modéliser les cinétiques de transformation des défauts Bore-Oxygène. Cet état D représente l'état du défaut après désactivation thermique et un état initial conduisant à l'état A après recuit thermique. Les auteurs ont, ainsi, proposé deux stratégies pour limiter la LID due à la présence de défauts Bore-Oxygène: soit favoriser l'état nommé D, soit favoriser l'état final inactif C, obtenu par l'activation de l'état A conduisant à l'état B suivie de sa désactivation, cette séquence étant appelée dégradation-régénération ou régénération. Le passage à l'état D est obtenu par une désactivation thermique de l'état A qui requiert un refroidissement rapide postérieur à un recuit à haute température avec mention qu'une température de recuit à 450°C peut être suffisante. Pour favoriser la régénération (Etat C), un recuit en four à passage pour permettre la diffusion d'hydrogène dans le volume et un recuit ultérieur sous illumination (de façon plus générale sous injection de porteurs) sont généralement nécessaires. La régénération pourrait impliquer la passivation par l'hydrogène du défaut Bore-Oxygène pleinement formé. En contraste, la désactivation thermique implique probablement la dissociation du défaut vers son état de précurseur sans rôle apparent de l'hydrogène. Lors de la désactivation pour le passage à l'état D, le recuit est réalisé à une température de 750°C au plus. Aucun détail n'est donné sur la notion de refroidissement rapide, mais il est fait référence aux trois publications suivantes mentionnées ci-dessous (S. W. Glunz *et al.,* 2001a, K. Bothe *et al.,* 2002 et D.C Walter *et al.,* 2014).

S. W. Glunz *et al.,* Sol. Energy Mater. Sol. Cells 2001 ont proposé des solutions consistant à éviter le bore ou l'oxygène dans le silicium de départ (utilisation de MCz-Si ou FZ-Si avec une très faible quantité, voire une absence d'oxygène interstitiel, substitution du bore par du gallium, notamment). Dans les cas où du bore et de l'oxygène interstitiel sont présents, S.W. Glunz *et al.* ont envisagé de réaliser un traitement thermique à haute température pour réduire la concentration de défauts Bore-Oxygène de manière permanente, ce qui s'est traduit par un gain de rendement photovoltaïque ou par l'augmentation de la durée de vie des porteurs de charge. Le traitement thermique consistait en une oxydation à haute température (variant de 850 à 1050°C). Rien n'est mentionné concernant le détail des conditions de refroidissement, dans cette publication.

K. Bothe *et al.,* 2002 ont étudié, quant à eux, les effets de différents traitements thermiques sur la densité de défauts Bore-Oxygène associés à la LID, à partir de N*. Ces auteurs ont étudié un silicium cristallin initialement de type p contenant du bore et de l'oxygène (FZ dopé O). Il a été constaté qu'un traitement prolongé jusqu'à 32 heures à 450°C réduisait la densité de défauts N*. A une température plus élevée (850°C dans un four à quartz), K. Bothe *et al.* ont montré qu'un traitement d'oxydation et un traitement de diffusion phosphore (POCl₃) avaient le même effet sur la réduction de N*, si le bilan thermique était similaire. K. Bothe *et al.* ont, également, mentionné qu'en utilisant une rampe de refroidissement plus rapide, une plus grande réduction de N* était obtenue, correspondant à une réduction de 70% environ par rapport au silicium initial (N* divisé par 3,5). Deux conditions de refroidissement qualifiées de lente et rapide ont été utilisées, sans que plus de précision ne soit donnée sur ces deux notions. Il convient de souligner que d'une manière générale, les rampes de refroidissement classiques conduisent à des refroidissements à une vitesse de 3 à 70 °C/s (voir, par exemple, H. Wagner *et al.,* 2016).

Enfin, D.C Walter *et al.,* 2014 ont identifié la vitesse de refroidissement après le recuit en four en passage comme un paramètre influençant la dégradation des défauts Bore-Oxygène et leur régénération. La vitesse de refroidissement a été modulée en modifiant la vitesse de défilement du tapis du four à passage. Les auteurs ont également mis en évidence que ces effets étaient indépendants de la présence d'hydrogène, puisque des études avec et sans couches diélectriques hydrogénées ont été menées.

Ainsi, il apparait que l'art antérieur ne propose pas de procédé permettant de réduire de manière satisfaisante la densité de défauts bore-oxygène entrainant la LID dans une plaquette de silicium cristallin comprenant du bore et de l'oxygène interstitiel. L'un des objectifs de l'invention est justement de proposer une nouvelle solution conduisant à des plaquettes de silicium cristallin, qui bien que contenant du bore et de l'oxygène, présentent une faible densité de défauts bore-oxygène entrainant la LID. En particulier, l'invention propose un nouveau procédé de traitement de plaquettes de silicium cristallin, permettant de diminuer drastiquement la densité de défauts bore-oxygène conduisant à la LID, par comparaison avec la densité présente avant ledit traitement. Ainsi, l'invention se propose, également, de fournir des plaquettes de silicium et des cellules photovoltaïques, ayant respectivement une durée de vie des porteurs de charge et un rendement photovoltaïque améliorés.

Description de l'invention

Dans ce contexte, la présente invention concerne un procédé de traitement d'une plaquette de silicium cristallin comprenant du bore et de l'oxygène interstitiel formant des défauts qui augmentent la sensibilité à l'illumination de la plaquette de silicium cristallin, nommés défauts Bore-Oxygène, ledit procédé de traitement conduisant à une réduction de la densité desdits défauts Bore-Oxygène, qui comprend une étape i) de chauffage de la plaquette de silicium cristallin à une température appartenant à la gamme allant de 650°C à 1200°C, caractérisé en ce que l'étape i) est suivie d'une étape ii) de refroidissement ultra-rapide qui démarre alors que la plaquette de silicium cristallin est encore à une température de 600°C au moins, et, lors de laquelle, la température de la plaquette de silicium cristallin est abaissée selon une vitesse de refroidissement qui appartient à la gamme allant de 150 à 2000 °C/s, jusqu'à atteindre une température de 400°C ou moins, de préférence jusqu'à atteindre une température de 300°C ou moins.

Dans le cadre de l'invention, la notion de « procédé de traitement d'une plaquette de silicium cristallin comprenant du bore et de l'oxygène interstitiel formant des défauts qui augmentent la sensibilité à l'illumination de la plaquette de silicium cristallin, nommés défauts Bore-Oxygène » peut être remplacé en tout lieu et place de la présente description de l'invention par « procédé de traitement d'une plaquette de silicium cristallin comprenant du bore et de l'oxygène interstitiel pour diminuer la sensibilité à l'illumination de la dite plaquette de silicium cristallin ». Dans le cadre de l'invention, les inventeurs proposent un cycle spécifique de traitement thermique ciblant l'élimination de l'effet LID dû aux défauts Bore-Oxygène (correspondant possiblement à des complexes formés entre les atomes de bore et des dimères d'oxygène interstitiel, d'après les études antérieures) en dissociant les précurseurs du complexe à haute température, lors de l'étape i) de chauffage et en les bloquant dans cet état, grâce à l'étape ii) de refroidissement ultra-rapide.

La solution proposée dans le cadre de l'invention n'était nullement évidente, car les inventeurs ont, tout d'abord, constaté que les plaquettes de silicium étaient soumises à des contraintes thermomécaniques trop élevées et se brisaient, lorsqu'une trempe dans l'eau était réalisée directement en sortie d'un chauffage thermique, ce qui conduit à une vitesse de refroidissement bien supérieure à celle proposée dans le cadre de l'invention. De manière surprenante, selon l'invention, le refroidissement ultra-rapide depuis une température qui peut être aussi élevée que 1000°C, notamment obtenu par une immersion de la plaquette mince (notamment d'une épaisseur <180 $\mu$m) de silicium cristallin de grande dimension (d'une surface de 156x156 mm$^2$ dans les exemples qui vont suivre) dans l'azote liquide ne génère pas de casse (ceci a fait l'objet d'un contrôle visuel, dans les exemples qui vont suivre), ni ne génère de plans de glissements qui pourraient être dus à des contraintes thermo-mécaniques trop élevées (ceci a été contrôlé par la DDV obtenue).

Selon des modes de réalisation particuliers, le procédé de traitement selon l'invention comprend en amont de l'étape i), une préparation préalable de la surface de la plaquette de silicium cristallin permettant de réduire les risques de contamination de la plaquette par des impuretés, lors de l'étape i) et/ou ii).

Selon certains modes de réalisation, le procédé de traitement selon l'invention comprend en amont de l'étape i), une préparation préalable de la surface de la plaquette de silicium cristallin, ladite préparation comprenant ou consistant en une étape de texturation de la surface de la plaquette de silicium cristallin et/ou une étape de retrait d'une zone écrouie présente en surface de la plaquette de silicium cristallin et/ou une étape de formation en surface de la plaquette de silicium cristallin d'une couche jouant le rôle de couche barrière ou d'une couche développant un effet getter. En particulier, la préparation préalable de la surface de la plaquette de silicium cristallin peut comprendre la formation d'une couche de phosphosilicate (PSG) développant un effet getter qui est réalisée sous atmosphère POCl$_3$, suivie d'un recuit conduisant à une diffusion phosphore dans la plaquette de silicium cristallin depuis sa surface, la couche de phosphosilicate pouvant ensuite être ou non retirée.

Selon d'autres modes de réalisation, le procédé de traitement selon l'invention comprend en amont de l'étape i), une préparation préalable de la surface de la plaquette de silicium cristallin, ladite préparation comprenant ou consistant en une étape de texturation de la surface de la plaquette de silicium cristallin et/ou une étape de retrait d'une zone écrouie présente en surface de la plaquette de silicium cristallin et, lors de l'étape i), la formation en surface de la plaquette de silicium cristallin d'une couche jouant le rôle de couche barrière ou d'une couche développant un effet getter est réalisée. En particulier, l'étape i) peut être réalisée sous atmosphère POCl$_3$, conduisant à la formation d'une couche de phosphosilicate (PSG) développant un effet getter et conduisant à une diffusion phosphore dans la plaquette de silicium depuis sa surface.

Quels que soient les modes de réalisation, dans le procédé de traitement selon l'invention, les étapes i) et ii) peuvent être réalisées dans les conditions de température suivantes :

- lors de l'étape i), le chauffage de la plaquette de silicium cristallin est réalisé à une température appartenant à la gamme allant de 700°C à 1050°C,

- lors de l'étape ii), le refroidissement ultra-rapide démarre alors que la plaquette de silicium cristallin est encore à une température de 600 °C au moins et la plaquette de silicium cristallin est abaissée selon une vitesse de refroidissement dans la gamme allant de 150 à 2000°C, jusqu'à atteindre une température de 400°C ou moins, de préférence jusqu'à atteindre une température de 300°C ou moins.

Typiquement, le procédé de traitement d'une plaquette de silicium cristallin selon l'invention, comprend les étapes i) et ii) suivantes :

- à l'étape i), un chauffage à une température d'environ 1000°C est réalisé, et

- lors de l'étape ii), le refroidissement ultra-rapide démarre alors que la plaquette de silicium cristallin est encore à une température de 800 °C au moins, et une vitesse de refroidissement supérieure dans la gamme de 200 à 600 °C/s est appliquée jusqu'à atteindre une température inférieure ou égale à 400°C et préférentiellement jusqu'à atteindre une température de 300°C ou moins.

9  EP 4 753 408 A1  10

Quels que soient les modes de réalisation, dans le procédé de traitement selon l'invention, lors de l'étape i) la plaquette de silicium cristallin est, avantageusement, chauffée à une température appartenant à la gamme allant de 650°C à 1200°C, de préférence à la gamme allant de 700°C à 1050°C, et typiquement à environ 1000°C, pendant une durée de 0,5 s à 120 min, de préférence pendant une durée de 1 s à 30 min.

En particulier, dans le procédé de traitement selon l'invention, lors de l'étape ii), le refroidissement ultra-rapide est réalisé par immersion, dans de l'azote liquide, de la plaquette de silicium cristallin.

Dans les procédés de traitement selon l'invention, le silicium cristallin peut être du silicium de type n ou du silicium de type p, notamment du silicium de type n compensé au bore. En particulier, le silicium cristallin est du silicium Cz, en particulier du silicium Cz de type n, notamment du silicium Cz de type n compensé au bore ou du silicium Cz de type n obtenu à partir de silicium recyclé ou de grade solaire.

Dans les procédés de traitement selon l'invention, le silicium cristallin de la plaquette de silicium cristallin contient, notamment, de $5.10^{13}$ à $5.10^{17}$ atomes/cm$^3$ de bore, préférentiellement de $10^{14}$ à $10^{17}$ atomes/cm$^3$, et encore plus préférentiellement de $10^{15}$ à $5.10^{16}$ atomes/cm$^3$ de bore et le silicium cristallin de la plaquette de silicium cristallin contient, notamment, de $8.10^{16}$ à $2,2.10^{18}$ atomes/cm$^3$ d'oxygène interstitiel, préférentiellement de $2.10^{17}$ à $2,2.10^{18}$ atomes/cm$^3$ d'oxygène interstitiel, et encore plus préférentiellement de $2.10^{17}$ à $7.10^{17}$ atomes/cm$^3$ d'oxygène interstitiel. A noter que $2.10^{17}$ à $7.10^{17}$ atomes/cm$^3$ peut également s'écrire $2E17$ à $7.E17$ cm$^{-3}$. Toutes les gammes ci-dessus données pour le bore et l'oxygène interstitiel peuvent être combinées entre elles. Selon un mode de réalisation particulier, notamment, le silicium cristallin de la plaquette de silicium cristallin contient de $10^{15}$ à $5.10^{16}$ atomes/cm$^3$ de bore et de $2.10^{17}$ à $7.10^{17}$ atomes/cm$^3$ d'oxygène interstitiel.

De manière avantageuse, les procédés de traitement selon l'invention, conduisent à une diminution d'au moins 85%, et préférentiellement à une diminution de 90% ou plus, de la densité de défauts « Bore-Oxygène ».

Un autre aspect de l'invention concerne les plaquettes de silicium cristallin Pt susceptibles d'être obtenues par le procédé de traitement selon l'invention. La DDV plus importante obtenue, alors que les quantités de bore et d'oxygène interstitiel sont importantes dans de telles plaquettes de silicium cristallins Pt met bien en évidence la différence par rapport aux plaquettes de silicium de l'art antérieur présentant des quantités de bore et d'oxygène interstitiel similaires.

L'invention a également pour objet un procédé de fabrication d'une cellule photovoltaïque, et en particulier d'une cellule photovoltaïque à hétérojonction, comprenant l'utilisation d'une plaquette de silicium cristallin Pt selon l'invention ou bien comprenant une étape consistant en la mise en œuvre du procédé de traitement selon l'invention conduisant à une plaquette de silicium cristallin Pt.

Un tel procédé de fabrication d'une cellule photovoltaïque comprend, notamment, une étape d'association de la plaquette de silicium cristallin Pt à au moins une couche semi-conductrice.

De manière avantageuse, un procédé de fabrication d'une cellule photovoltaïque selon l'invention ne comprend aucune étape de chauffage à une température de chauffage supérieure à 300°C mise en œuvre sur la plaquette de silicium cristallin Pt et, de préférence, il ne comprend aucune étape de chauffage à une température de chauffage mise en œuvre sur la plaquette de silicium cristallin Pt supérieure à 250°C. Par étape de chauffage mise en œuvre sur la plaquette de silicium cristallin Pt, on entend une étape de chauffage une fois que la plaquette de silicium cristallin Pt est obtenue, sachant que l'absence d'une telle étape de chauffage concerne également la plaquette de silicium cristallin Pt éventuellement modifiée ou associée à une ou plusieurs couches, en fonction de l'utilisation visée.

L'invention a également pour objet les cellules photovoltaïques fabriquées à partir d'une plaquette de silicium cristallin Pt selon l'invention ou bien susceptibles d'être obtenues par le procédé de fabrication d'une cellule photovoltaïque selon l'invention.

Description détaillée de l'invention

D'autres caractéristiques, détails et avantages de l'invention ressortiront à la lecture de la description faite en référence aux figures annexées données à titre d'exemple.

Description détaillée des figures

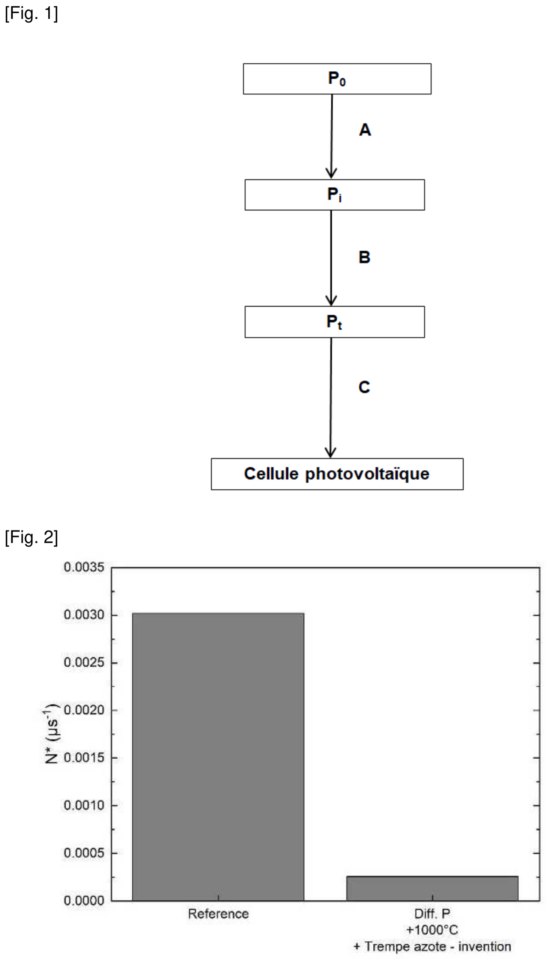

La [Fig.1] présente schématiquement différentes étapes que peuvent comprendre un procédé de traitement et un procédé de fabrication d'une cellule photovoltaïque proposés selon 'invention. La Plaquette de silicium cristallin $P_0$ peut donner après un traitement de surface (A sur la Figure) la plaquette de silicium cristallin Pi qui elle-même donne la plaquette de silicium cristallin Pt, par mise en œuvre de l'étape i) de chauffage, suivie de l'étape ii) de refroidissement ultra-rapide (B sur la Figure). Enfin, la plaquette de silicium cristallin Pt, est soumise aux étapes d'un procédé de fabrication d'une cellule photovoltaïque, par exemple, dépôt de couches semi-conductrices, diélectriques, recuit à une température < 300°C, d'exposition à la lumière, nommée « light soaking » ... (C sur la Figure) pour donner la cellule photovoltaïque.

La [Fig.2] est une illustration de la baisse de la

6

concentration de défauts N* en utilisant un procédé de traitement selon l'invention sur une plaquette de silicium Cz de type n. La référence est une plaquette similaire qui n'a pas subi le traitement selon l'invention.

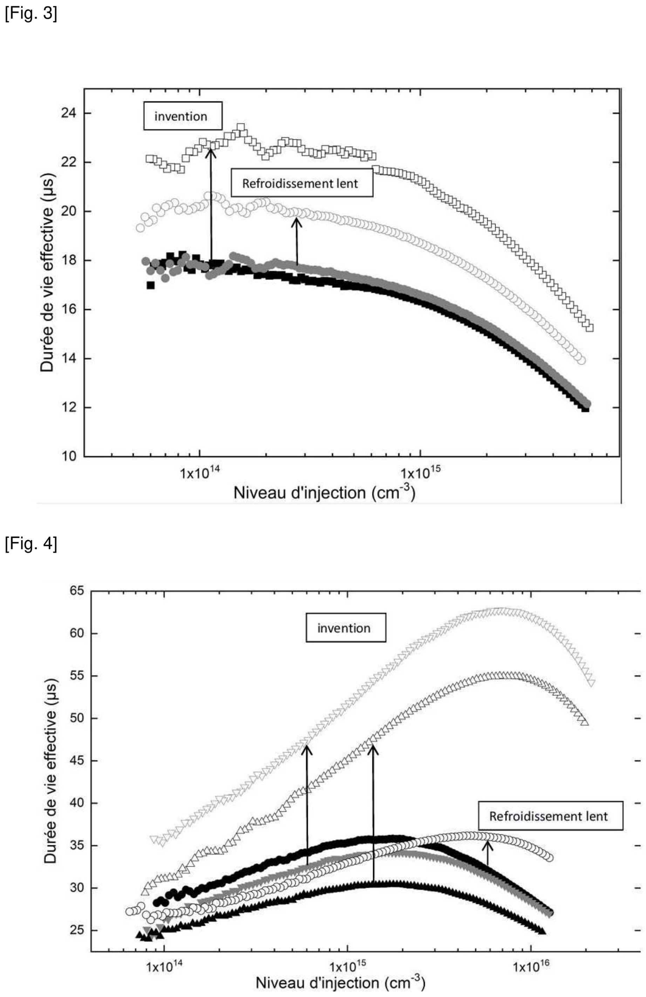

La [Fig.3] est une illustration de l'augmentation de la durée de vie effective des porteurs de charge ($\tau$ eff en $\mu$s présentée en fonction du niveau d'injection en cm-3) obtenue à l'exemple 2 en utilisant un procédé de traitement selon l'invention (courbe □) sur une plaquette de silicium cristallin Cz de type p (dopage au bore), avec formation d'une couche getter par diffusion phosphore, en comparaison avec un refroidissement lent (courbe o). Le niveau d'injection est la concentration de porteurs excédentaires (p/r à l'état d'équilibre) dans le silicium.

La [Fig.4] est une illustration de l'augmentation de la durée de vie effective des porteurs de charge ($\tau$ eff en $\mu$s présentée en fonction du niveau d'injection en cm-3) obtenue à l'exemple 2 en utilisant un procédé de traitement selon l'invention (courbes avec symbole $\Delta$) sur une plaquette de silicium cristallin Cz de type p (dopage au bore), sans formation d'une couche getter par diffusion phosphore, en comparaison avec un refroidissement lent (courbe o).

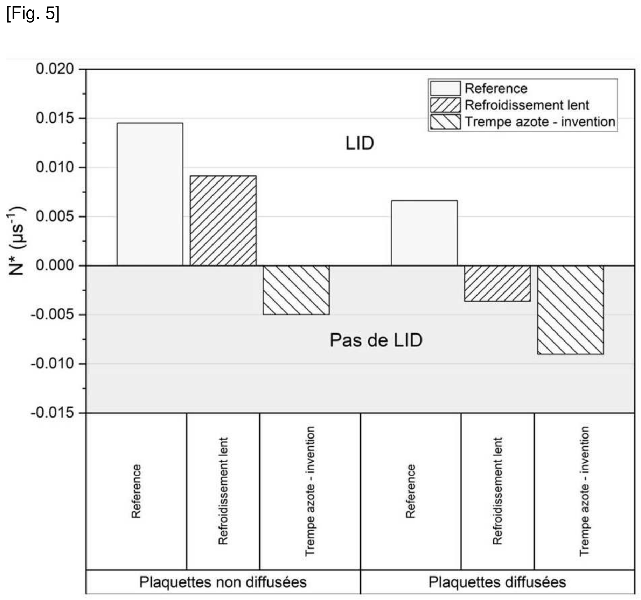

La [Fig.5] présente les effets du recuit (étape i)) et du mode de refroidissement (étape ii)), par comparaison avec un autre type de refroidissement lent, sur les valeurs de N*, obtenus à l'exemple 2. Des N* négatifs signifient que la durée de vie effective a augmenté sous éclairement. Les valeurs de N* ont été calculées à partir de mesures de $\tau$ eff extraites à un niveau d'injection de $3 \times 1014$ cm-3.

Définitions

A moins qu'il n'en soit spécifié autrement, les termes utilisés dans la présente description ont la signification généralement reconnue par l'homme du métier.

Les notions de « de l'ordre » ou « environ » signifie qu'une variation de 5% au plus, de 4% au plus, de 3% au plus, de 2% au plus et, de préférence, de 1% au plus, autour de la valeur donnée est tolérée. Une identité avec la valeur donnée est, cependant, préférée.

Le silicium cristallin des plaquettes soumises au procédé de traitement selon l'invention peut être du silicium monocristallin ou multicristallin. De manière avantageuse, le silicium est du silicium monocristallin, notamment obtenu par tirage Czochralski. Le silicium cristallin peut être obtenu par diverses méthodes de solidification : du silicium Czochralski (ou Si Cz), du silicium cristallin obtenu par la méthode Bridgman (ou solidification dirigée), du silicium cristallin obtenu par la technique de cristallisation en zone (en anglais « float zone », nommé FZ-Si), du silicium Czochralski magnétique (MCz).

Le bore présent dans le silicium cristallin peut provenir d'un dopage souhaité, dans le cas d'un silicium cristallin de type p dopé au bore ou d'un silicium cristallin de type n compensé au bore. Le bore peut également être présent en tant que contaminant, c'est, en particulier, le cas d'un silicium cristallin obtenu à partir du silicium de grade solaire (UMG), de silicium recyclé ou de certains siliciums polycristallins obtenus par lit fluidisé.

Dans le cadre de l'invention, la quantité de bore ou de phosphore dans le silicium cristallin peut être déterminée par spectrométrie de masse des ions secondaires (SIMS). La quantité d'oxygène interstitiel dans le silicium cristallin peut être déterminée par spectroscopie infrarouge à transformée de Fourier (FTIR), selon la norme ASTM 1188, dans sa version en vigueur au 1$^{er}$ juillet 2024.

Une grandeur caractéristique de la quantité de défauts Bore-Oxygène qui augmentent la sensibilité à l'illumination (LID) de la plaquette de silicium cristallin peut être calculée à partir de la durée de vie (DDV) des porteurs de charge, comme décrit par Walter *et al.,* 2014. Comme dans les publications de l'art antérieur, ladite grandeur caractéristique de la concentration ou quantité est nommée, généralement, N*. La durée de vie effective des porteurs de charge ($\tau$ eff) est mesurée avant ($\tau$ ini) et après ($\tau$ fin) un temps sous éclairement suffisamment long (expérimentalement vérifié) pour former tous les complexes Bore-Oxygène. La durée de vie effective des porteurs de charge ($\tau$ eff) a été déterminée par photoconductivité, avec un équipement Sinton WCT-120, en fonction du niveau d'injection. Typiquement, dans le cadre de l'invention, une illumination de 0,5 soleil pendant 60 minutes est appliquée. De ces mesures, effectuées pour un niveau d'injection identique sélectionné, sont extraites les données caractéristiques des concentrations relatives de complexes Bore-Oxygène formés (N*).

$$N^* = 1/\tau \text{ fin} - 1/\tau \text{ ini}$$

Description détaillée du procédé de traitement de l'invention et de certains modes de réalisation

Comme cela ressort de la figure 1, le procédé de traitement selon l'invention permettant de diminuer la sensibilité à la lumière (LID) d'une plaquette de silicium cristallin, par diminution de la densité de défauts Bore-Oxygène à l'origine de la LID, comprend une première étape i) de traitement thermique à haute température, suivie d'une deuxième étape ii) de refroidissement ultra-rapide. La plaquette Pt de silicium cristallin ainsi obtenue peut alors subir les autres étapes nécessaires à la fabrication d'une cellule photovoltaïque hétérojonction, que sont, notamment, les dépôts de couches semi-conductrices, d'oxyde transparent conducteur, de recuit à une température inférieure à 250°C, d'exposition à la lumière, nommée « light soaking ». En amont de l'étape i), la plaquette de silicium cristallin subira, généralement, un traitement de surface pour éviter les contaminations chimiques lors de la première étape i) de traitement thermique, ainsi que lors du refroidissement de l'étape ii). Les différents traitements possibles seront détaillés plus loin. La plaquette de silicium cristallin, avant le traitement de surface (pouvant comprendre une ou plusieurs étapes) est nommée $P_0$, alors que celle obtenu après le traitement de surface est nommée $P_i$. La plaquette de silicium cristallin $P_i$ a, de manière classique, une épaisseur de 5 $\mu$m à 2 mm, en particulier de 40 $\mu$m à 200 $\mu$m. Sa surface est de 0,02 à 0,05 m$^2$, de préférence de 0,03 à 0,045 m$^2$.

L'étape i) de chauffage peut être réalisée dans tout dispositif de chauffage adapté, permettant d'atteindre la température visée qui appartient à la gamme allant de 650°C à 1200°C. En particulier, un four à infra-rouge (IR), un four résistif, un four à tube quartz vertical ou un four à passage, peut être utilisé. Le temps de chauffage de l'étape i), correspondant à la durée de maintien de la plaquette de silicium cristallin Pi dans le dispositif de chauffage, sera fonction de la nature de cette dernière et du temps nécessaire pour que la plaquette de silicium atteigne la température de chauffage visée à laquelle le dispositif de chauffage est maintenu. Pour obtenir le résultat souhaité, un temps de maintien de la température de la plaquette de silicium à une température Tc de 650°C à 1200°C, de préférence de 700°C à 1050°C, pendant 0,5 à 2s, et typiquement pendant environ 1s pourra être suffisant. Le temps de chauffage de l'étape i) sera généralement supérieur à cette durée, pour tenir compte du temps que la plaquette atteigne la température visée. Ainsi, la durée de maintien de la plaquette dans le dispositif de chauffage sera fonction dudit le dispositif et variera de 0,5 s (seconde) à 120 min (minutes), de préférence de 1s à 30 min, généralement.

L'étape i) de chauffage peut être réalisée dans tout type d'atmosphère : notamment, sous air, sous atmosphère de diffusion phosphore (par exemple du type POCl$_3$) ou sous atmosphère inerte du type azote ou argon. Le chauffage est, généralement, réalisé sous pression atmosphérique (c'est-à-dire à une pression de 1 013,25 hPa).

Ensuite, la plaquette de silicium cristallin encore chaude est soumise à un refroidissement avec une vitesse de refroidissement qui appartient à la gamme allant de 150 à 2000°C/s, avantageusement à la gamme allant de 200 à 1000°C/s, et de manière encore plus préférée à la gamme allant de 200°C/s à 600°C/s.

Cette vitesse est très rapide et est totalement inhabituelle, c'est pourquoi elle est qualifiée d'ultra-rapide dans le cadre de l'invention. Le refroidissement ultra-rapide peut débuter directement à la température Tc ou bien à une température inférieure du fait d'un premier refroidissement intervenant lors de la sortie de la plaquette de silicium de l'installation de chauffage. L'important est que le refroidissement ultra-rapide démarre alors que la plaquette de silicium est à une température suffisamment élevée, dans laquelle les défauts Bore-Oxygène ont été désactivés/dissociés, l'étape de refroidissement ultra-rapide ayant pour objectif d'empêcher la formation des précurseurs à l'origine des défauts Bore-Oxygène, du fait d'un abaissement brutal de la température. Ainsi, la phase de refroidissement ultra-rapide peut intervenir sur une gamme de température démarrant à la température Tc, ou à une température moindre, notamment démarrer à une température appartenant à la gamme allant de 600 à 850°C, en fonction de la température de chauffage Tc appliquée lors de l'étape i).

La phase de refroidissement ultra-rapide dans la gamme de vitesse d'intérêt est obtenue avantageusement en plaçant la plaquette de silicium dans un environnement refroidissant adapté ou au contact d'un élément refroidissant adapté, ledit environnement refroidissant ou ledit élément refroidissant ayant une température de -40°C ou moins, notamment une température dans une gamme de -100°C à -250°C et typiquement de l'ordre de -200°C. L'étape ii) peut se faire par immersion de la plaquette de silicium cristallin encore à une température élevée, dans un environnement refroidissant ayant une température de -40°C ou moins, cette immersion étant également nommée trempe. Cet environnement refroidissant est en particulier de l'azote liquide (qui a une température de -196°C) ou gazeux. Le refroidissement peut être obtenu directement par trempe de la plaquette de silicium dans l'azote liquide, comme illustré dans les exemples, par un passage intermédiaire dans l'azote gazeux à l'interface. Il est également possible de placer la plaquette de silicium dans un environnement refroidissant constitué d'un environnement gazeux refroidi à une température proche celle de l'azote liquide, grâce à de l'azote liquide. Un tel environnement gazeux peut être de l'air, de l'azote, de l'argon ou encore de l'hydrogène ou de l'hélium, par exemple. Il est également possible de placer la plaquette de silicium au contact d'un élément refroidissant, tel qu'un élément de préemption ou un support refroidi à une température de -40°C ou moins, par exemple, avec de l'azote liquide.

Le positionnement de l'environnement refroidissant ou de l'élément refroidissant utilisé à l'étape ii) par rapport à la zone chaude du dispositif de chauffage utilisé lors de l'étape i) sera adapté pour minimiser la baisse de température avant l'étape ii) permettant de figer la dissociation des précurseurs à l'origine des défauts Bore-Oxygène obtenue à l'étape i). En particulier, il pourra être prévu de positionner l'environnement refroidissant, notamment le bain d'azote liquide, ou une chambre destinée à l'accueillir, directement sous le dispositif de chauffage et de remplir ladite chambre par l'environnement refroidissant par actionnement d'une vanne, puis de faire tomber la plaquette de silicium cristallin dans ledit environnement par l'action d'une trappe.

Il pourrait également être prévu de sortir très rapidement la plaquette de silicium du dispositif de chauffage et de la soumettre à une diffusion ou projection de gaz refroidi avec de l'azote liquide. Une autre voie de refroidissement ultra-rapide serait de déposer la plaquette de silicium en sortie du dispositif de chauffage sur un support refroidi dont la surface serait à une température inférieure à -40°C, notamment grâce à de l'azote liquide. Alternativement, il est possible d'utiliser un dispositif de préhension de la plaquette de silicium dans le dispositif de chauffage qui lui-même est préalablement refroidi à une température inférieure à -40°C ou refroidi en continu, à une température inférieure à -40°C par exemple avec l'azote liquide.

La vitesse de refroidissement dans la gamme allant de 150 à 2000°C/s peut être appliquée sur une gamme de températures de 800°C à 400°C, ou sur une gamme de température plus ou moins large, qui est fonction notamment de la température Tc de chauffage qui peut être supérieure ou inférieure à 800°C. En particulier, la vitesse de refroidissement de 150 à 2000°C/s peut être appliquée jusqu'à atteindre une température de 400°C, voire de 300°C, 250°C ou 200°C. La vitesse de refroidissement lors de l'étape ii) peut notamment être de 200 à 600°C/s, notamment de 300 à 400°C et typiquement de l'ordre de 300°C/s. L'important est que la vitesse de refroidissement qui appartient à la gamme allant de 150 à 2000°C/s, avantageusement à la gamme allant de 200 à 1000°C/s, et de manière encore plus préférée à la gamme allant de 200°C/s à 600°C/s soit maintenue sur une gamme de températures lors de laquelle les défauts Bore-Oxygène ont la capacité de se reformer. Cette gamme de température correspond, en particulier, à la gamme de température allant de 600 à 400°C, mais la vitesse de refroidissement ultra-rapide pourra être maintenue sur une gamme de température plus importante, notamment pour des raisons pratiques. Ensuite, même si la plaquette de silicium est maintenue dans l'environnement refroidissant ou au contact de l'élément refroidissant, la baisse de température est plus lente. Notamment, lorsque le refroidissement est réalisé par immersion dans de l'azote liquide, la plaquette de silicium peut être maintenue immergée jusqu'à atteindre la température de l'azote liquide ou être retirée plus tôt, ceci n'étant pas déterminant dès lors que la vitesse de refroidissement de 150 à 2000°C/s est appliquée jusqu'à atteindre une température de 400°C, voire de 300°C, 250°C ou 200°C. Une fois la température de la plaque de silicium ayant atteint une température de 400°C, voire de 300°C, 250°C ou 200°C, la vitesse de refroidissement peut être plus lente, sans influencer le résultat obtenu dans le cadre de l'invention de réduction des défauts Bore-Oxygène.

La température de la plaquette de silicium cristallin et donc la vitesse de refroidissement peuvent être mesurées par tout moyen approprié. De manière classique, un thermocouple placé sur la plaquette de silicium cristallin est utilisé.

La plaquette de silicium cristallin Pi soumise à l'étape i) de chauffage résulte le plus souvent d'une étape préalable de traitement qui autorise, ainsi, un chauffage de la plaquette en minimisant, voire en évitant, les mécanismes de contaminations par des impuretés, notamment métalliques, lors du chauffage de l'étape i). En effet, de telles contaminations par des impuretés, notamment métalliques, auraient pour conséquence de dégrader la durée de vie des porteurs de charge de la plaquette. Si un four suffisamment propre, avec un chauffage sous atmosphère inerte, est utilisé, une telle étape de traitement pourrait être omise.

De tels traitements sont classiques pour l'homme du métier. Ainsi, pour donner la plaquette de silicium cristallin Pi soumise aux étapes successives i) et ii), une plaquette de silicium cristallin, dite originale nommée Po, peut subir, une étape de texturation de sa surface, une étape de retrait de la zone écrouie, notamment, une étape de dépôt d'une couche jouant le rôle de couche barrière, ou encore la formation d'une couche à effet Getter. Il est possible de réaliser tout d'abord une étape de retrait de la zone écrouie, puis une étape de dépôt/formation d'une couche jouant le rôle de couche barrière et formant une couche à effet Getter ou encore de réaliser tout d'abord une étape de retrait de la zone écrouie, puis une étape de texturation, puis une étape de dépôt d'une couche jouant le rôle de couche barrière et permettant la formation d'une couche à effet Getter.

En particulier, la plaquette de silicium cristallin Po est, le plus souvent, directement obtenue du découpage d'un lingot de silicium cristallin. Une zone écrouie sur une plaquette de silicium cristallin Po fait référence à une région de la plaquette où le silicium a subi un écrouissage, c'est-à-dire une déformation due à un traitement mécanique. Ce phénomène se produit généralement lors des étapes de sciage, de polissage ou d'autres procédés mécaniques dans la fabrication des plaquettes de silicium à partir du lingot. Le retrait d'une zone écrouie peut se faire, notamment, par traitement chimique, par exemple à partir de solutions contenant du KOH.

L'étape de texturation, lorsqu'elle est mise en œuvre, est menée selon les techniques bien connues de la personne du métier. Il peut s'agir d'un traitement avec une solution alcaline (typiquement d'hydroxyde de potassium ou d'hydroxyde de sodium) ou acide (typiquement d'acide fluorhydrique ou d'acide nitrique), ou d'une texturation par laser, par plasma, par gravure humide, par sablage ou grenaillage. Le traitement sera adapté en fonction de la plaquette de silicium cristallin Po utilisée. En particulier, une texturation par traitement avec une solution alcaline est plus adaptée dans le cas d'une plaquette Po de silicium monocristallin, alors qu'une texturation par traitement avec une solution acide est plus adaptée dans le cas d'une plaquette Po de silicium polycristallin. De façon préférentielle, les étapes de traitement chimique permettant d'enlever la couche écrouie sont suivies d'une ou plusieurs étapes de nettoyage des surfaces de la plaquette de silicium, par exemple via des bains d'HF.

Le choix de cette étape de préparation sera adaptée par l'homme du métier, en fonction du chauffage mis en œuvre à l'étape i) et de son potentiel pouvoir contaminant, notamment en fonction de l'atmosphère utilisée lors de ce chauffage, de l'équipement ou du support avec lequel la plaquette de silicium cristallin est en contact lors du chauffage. En particulier, le dépôt d'une couche barrière en surface sera préconisé, lorsque le chauffage est réalisé dans une atmosphère au pouvoir oxydant, notamment sous air. De manière connue, une telle couche barrière est, par exemple, une couche de nitrure de silicium (pouvant avoir différente teneur en azote, communément nommé $SiN_x$), d'oxyde de silicium $SiO_x$, d'oxyde d'aluminium, de $HfO_2$ ou $SiO_xN_y$. Une telle couche barrière a, généralement, une épaisseur de 2 nm à 500nm, notamment de 10 à 300 nm. Une telle couche peut être formée par toute technique appropriée, notamment de dépôt de couche mince. Dans le cas d'une couche $SiO_x$, une telle couche peut également être formée par oxydation.

La formation d'une couche à effet Getter (de façon plus précise à effet Getter externe) sera, notamment, mise en œuvre en présence de contaminants métalliques directement dans la plaquette de silicium ou lors de l'étape i). Une couche à effet Getter capture ou immobilise les impuretés métalliques à la surface du substrat silicium. Une telle couche peut être créée, de manière connue, de la personne du métier, notamment par traitement chimique ou physique. Il peut s'agir d'une couche de surface dopée au phosphore obtenue par diffusion de phosphore à partir d'une couche de verre phosphosilicate (PSG) formée en surface de la plaquette de silicium, à l'aide de $POCl_3$, lors d'un traitement thermique à une température le plus souvent de l'ordre de 850 à 900°C. Après diffusion du phosphore, la couche PSG peut être conservée ou enlevée (par exemple à l'aide d'une solution d'acide fluorhydrique) pour obtenir la plaquette de silicium cristallin Pi soumise aux étapes i) et ii). De façon avantageuse, le verre PSG peut être conservé car il peut jouer le rôle de couche barrière. Une couche barrière additionnelle, notamment de nitrure de silicium peut également être utilisée.

Il est également possible qu'une couche à effet getter, notamment de type PSG, soit formée lors de l'étape i). Dans ce cas, le traitement thermique de l'étape i) est réalisé sous atmosphère $POCl_3$ et, ainsi, la formation du PSG puis la diffusion de la zone au phosphore s'effectuent pendant l'étape i).

De manière classique également, avant et/ou après l'étape de traitement de surface, la plaquette de silicium est nettoyée pour éliminer les contaminants de surface tels que les particules, les oxydes natifs et les résidus organiques. Cela peut impliquer des bains chimiques (par exemple, de l'acide sulfurique et de l'eau oxygénée, également des bains d'HF/HCl) et un rinçage à l'eau déionisée. Après le nettoyage, la plaquette de silicium est séchée, souvent à l'aide d'un séchoir à azote. A noter que si une couche à effet getter a été utilisée, celle-ci pourra être retirée, par exemple par décapage chimique via une solution contenant du KOH.

Procédé de fabrication de cellule phovoltaïque et cellule photovoltaïque correspondante

Le procédé de traitement selon l'invention peut être intégré dans un procédé de fabrication d'une cellule photovoltaïque, et en particulier d'une SHJ. Il intervient avant l'association de la plaquette de silicium cristallin Pi, avec la ou les autres couches de matériau semi-conducteur (typiquement les couches de silicium amorphes), oxyde transparent conducteur, voire diélectrique, nécessaires. En particulier, en intervenant avant l'étape d'exposition à la lumière, dite « light soaking » mise en œuvre en fin de fabrication d'une cellule photovoltaïque, le procédé de traitement selon l'invention évite une dégradation du rendement photovoltaïque, lors de cette exposition à la lumière.

Le procédé de traitement selon l'invention est parfaitement adapté pour obtenir des plaquettes de silicium cristallin Pi utilisées dans tout procédé de fabrication de cellules photovoltaïques, dans lesquels aucun traitement ultérieur n'intervient à une température supérieure à 300°C, voire à une température supérieure à 250°C, après intégration de la plaquette de silicium cristallin Pi dans le procédé de fabrication. C'est en particulier le cas des procédés de fabrication des SHJ. En effet, un chauffage à une température supérieure à une température de 250°C à 300°C, en fonction du temps de chauffage, pourrait avoir pour effet de reformer les défauts Bore-Oxygène qui augmentent la sensibilité à l'illumination de la plaquette de silicium cristallin.

Dans de tels procédés, la plaquette de silicium cristallin Pi est associée sur chacune de ses faces à des couches à base de silicium amorphe hydrogéné ou de silicium nanocristallin hydrogéné ou à base d'oxyde(s) de métaux de transition.

Plus de détails sur les procédés de fabrication de cellules photovoltaïques pouvant être utilisés dans le cadre de l'invention peuvent être trouvés dans S. Zhaoking *et al.,* 2022.

Exemples de mise en œuvre

Exemple 1 - silicium de type n

Résultats préliminaires

Des premières expérimentations ont montré que des traitements de type diffusion phosphore ou recuit en four à passage à forte vitesse de passage menés sur des plaquettes de silicium cristallin de type n contaminés au bore pour cellules SHJ étaient insuffisants en terme de réduction de la densité de défauts bore-phosphore, matérialisée par la mesure de N\*. L'évolution de la durée de vie des porteurs de charge, en fonction du temps en conditions de la dégradation LID ont montré :

- Pour une référence 1 (silicium cristallin Cz de type n sans bore) aucune dégradation de la DDV n'est constatée,

- Pour une référence 2 (silicium cristallin Cz de type n avec présence de bore) sans pré-traitement, une forte dégradation de la DDV a été constatée. La concentration en Bore était d'environ $1,5.10^{16}$ cm$^{-3}$. La concentration en oxygène interstitiel était dans la gamme $6-8.10^{17}$ cm$^{-3}$.

- Pour la référence 2 soumise à une diffusion phosphore avec conservation de la couche PSG, suivie d'un traitement thermique à 700°C et 1000°C dans un four IR à passage, avec deux vitesses de défilement de 7,2 m/min et 4 m/min,a réduction de N* était significative, dans les deux cas, avec application du traitement thermique. Néanmoins, la suppression des défauts N* n'était pas satisfaisante et contrairement aux résultats des publications de l'art antérieur précédemment commentées, la réduction de N* était du même ordre de grandeur à basse et haute température (700/1000°C) ou à moyenne et forte vitesse de passage. La réduction obtenue des défauts N* était en effet limitée autour de 80 $\pm$ 5% de la densité initiale de défauts y compris pour la plus forte vitesse de passage correspondant à priori à la plus forte vitesse de refroidissement d'après D.C. Walter *et al.* 2014.

Mise en œuvre du procédé de traitement selon l'invention

Une plaquette de silicium de type n compensé au bore (quantité de bore : 6 $10^{15}$ cm$^{-3}$ à 8. $10^{15}$ cm$^{-3}$et quantité d'oxygène interstitiel : $5.10^{17}$cm$^{-3}$ à $7.10^{17}$.cm$^{-3}$) a été soumise à une diffusion phosphore dans un four à tube résistif, suivie d'un recuit à 1000 °C pendant 5 s, puis d'une trempe dans l'azote liquide directement en sortie du four. Le verre PSG formé pour la diffusion phosphore n'avait pas été enlevé préalablement aux étapes de recuit et de trempe. A titre de comparaison, un refroidissement par trempe dans l'azote liquide correspond à un refroidissement à une vitesse de -300°C/s, pendant 0,65s pour passer de la température de 600°C obtenue en sortie du four à 400°C, alors qu'un refroidissement naturel du même type que celui décrit à l'exemple 2, de la température de 600°C obtenue en sortie du four à 400°C se produit avec une vitesse de refroidissement de -30°C/s et dure environ 6,7s.

Il ressort de la figure 2 que le procédé selon l'invention a conduit à une réduction de la concentration normalisée de défaut Bore-Oxygène (N*) à hauteur de 91 $\pm$ 5%.

De plus, aucune apparition de défauts variés n'a été constatée par la présence dans le volume du substrat de métaux électriquement actifs (c'est à dire, affectant la durée de vie des porteurs), non piégés sur la couche getter, qu'auraient pu causer les étapes de recuit et de refroidissement ultra-rapide.

Exemple 2 - silicium de type p

Dans cet exemple, les plaquettes utilisées étaient des plaquettes monocristallines Cz, de type p, dopées au bore, dans lesquelles la quantité d'atomes de bore était de $9,1.10^{15}$ cm$^{-3}$ et la quantité d'oxygène interstitiel de $6.10^{17}-2.10^{18}$ cm$^{-3}$. La résistivité de ces plaquettes était de 1,6 ohm.cm, la surface de 125$\times$125 mm $^2$. La surface de ces plaquettes a été décapée par polissage chimique, conduisant à l'enlèvement de la zone écrouie.

Chaque plaquette a été découpée en 4 plaquettes plus petites (nommées échantillon) de surface 50$\times$50 mm$^2$. Comme les propriétés cristallographiques, électriques et compositionnelles du silicium Cz varient de façon circulaire sur la surface d'une plaquette, cette variation étant centrée sur le centre de la plaquette, **il** peut être considéré les 4 échantillons issus d'une même grande plaquette comme étant identiques. Tous les échantillons étudiés ont été repérés par gravure laser.

La moitié des échantillons a subi une étape de formation d'une couche PSG (phosphosilicate) en surface du silicium réalisée dans un four à tube, en présence de POCl$_3$, qui après recuit à une température de 1000°C a permis de générer une couche diffusée au phosphore. Le verre PSG a ensuite été retiré par traitement chimique (avec une solution d'HF). Ensuite, tous les échantillons ont subi des dépôts PECVD de couches de nitrure de silicium (couche barrière) afin de passiver électriquement les surfaces.

Ensuite, les quatre échantillons ont été soumis aux étapes suivantes :

- un échantillon a servi de référence (pas de recuit à 750°C)
- un échantillon a été recuit à 750°C sous air pendant 10 minutes (traitement thermique de l'étape i)), la porte du four a ensuite été ouverte et l'échantillon a été sorti du four et déposé sur une plaque permettant un refroidissement « à l'ambiante » de l'échantillon (cette condition a été qualifié de refroidissement « lent » par rapport aux autres conditions de refroidissement étudiées).
- un échantillon a été recuit à 750°C sous air pendant 10 minutes (traitement thermique de l'étape i)), la porte du four a ensuite été ouverte et l'échantillon plongé dans un bain d'eau glacée.
- un échantillon a été recuit à 750°C sous air pendant 10 minutes (traitement thermique de l'étape i)), la porte du four a ensuite été ouverte et l'échantillon plongé dans un bain d'azote liquide, pour la mise en œuvre du procédé de traitement selon l'invention de l'exemple 1.

Tout d'abord, il convient de souligner qu'aucune immersion dans le bac d'eau glacée n'a permis d'obtenir des plaquettes exploitables. En effet, cette étape a brisé les plaquettes en morceaux, certainement du fait de la variation très brutale de température bien supérieure à celle résultant d'une trempe dans l'azote liquide. Par contre, l'immersion dans l'azote liquide n'a pas entrainé de casses des plaquettes, certainement du fait de la présence d'azote sous forme de gaz à l'interface avec l'azote liquide conduisant à une vitesse de refroidissement selon l'invention.

Les figures 3 et 4 mettent en évidence l'effet du refroidissement, réalisé après un recuit à 750°C pendant 10 minutes, sur la durée de vie effective (τ eff) des porteurs de charge, respectivement pour les plaquettes de silicium de type p, ayant subi l'étape de diffusion phosphore et pour les plaquettes n'ayant pas subi une étape de diffusion phosphore. Il apparait clairement que l'immersion dans l'azote liquide permet toujours d'augmenter significativement la τ eff des porteurs de charge. Ainsi, les propriétés de passivation des couches de nitrure de silicium ne semblent pas être altérées par cette étape et le recuit sous air n'a pas, non plus, affecté les propriétés volumiques des plaquettes.

La figure 5 présente les effets du recuit et du mode de refroidissement sur les valeurs de N*. Il apparait que le recuit suivi de la trempe dans l'azote liquide a permis d'éliminer (ou du moins de réduire de façon très conséquente) les effets de LID. Pour quelques plaquettes, une augmentation de la τ eff a même été observée sous éclairement. Le recuit suivi d'un refroidissement « lent » donne également des résultats positifs. Il convient, cependant, de noter que ce type de refroidissement est tout de même rapide, comparé à celui obtenu, par exemple, en sortie d'un four à tube traditionnel, puisque dans le cas du refroidissement lent utilisé ici à titre de comparaison, les plaquettes ont été rapidement extraites du four à l'aide d'une pince, et posées sur un support en silice à l'extérieur du four, ce qui n'est pas habituel. Le trempage dans l'azote liquide conforme à l'invention donne, de loin, les meilleurs résultats.

Références

L.J. Caballero et al., Influence of Pgettering thermal step on light-induced degradation in Cz Si, Solar Energy Materials & Solar Cells 88 (2005) 247-256.

K. Bothe et al., Effective reduction of the metastable defect concentration in boron-doped Czochralski silicon for solar cells, in: Proceedings of Conf. Rec. Twenty-Ninth IEEE Photovolt. Spec. Conference, IEEE, New Orleans, (2003) 194-197, https://dx.doi.org/10.1109/PVSC.2002.1190489.

S. W. Glunz et al., Minority carrier lifetime degradation in boron-doped Czochralski silicon, J. Appl. Phys., Vol. 90, No. 5, 1 September (2001).

S. W. Glunz et al., Degradation of carrier lifetime in Cz silicon solar cells, Sol. Energy Mater. Sol. Cells 65 (2001) 219-229.

N. Nampalli et al., Multiple pathways for permanent deactivation of boron-oxygen defects in p-type silicon, Solar Energy Materials and Solar Cells 173 (2017) 12-17.

F.E. Rougieux et al., Influence of net doping, excess carrier density and annealing on the boron oxygen related defect density in compensated n-type silicon, J. Appl. Phys., Vol. 110, 063708 (2011).

H. Wagner et al., Optimizing phosphorus diffusion for photovoltaic applications: Peak doping, inactive phosphorus, gettering, and contact formation, J. Appl. Phys. 119, 185704 (2016), https://doi.org/10.1063/1.4949326.

D.C. Walter et al., Effect of rapid thermal annealing on recombination centers in boron-doped Czochralski-grown silicon, Appl. Phys. Lett. 104 (2014) 42111, https://dx.doi.org/10.1063/1.4863674.

Z.Y. Yeo et al., Status review and future perspectives on mitigating light-induced degradation on silicon-based solar cells, Solar Energy Materials & Solar Cells 131 (2014) 51-57.

S. Zhaoking et al., Toward Efficiency Limits of Crystalline Silicon Solar Cells: Recent Progress in High-Efficiency Silicon Heterojunction Solar Cells, Advanced Energy Materials, vol.12(23), 2200015, (2022), https://onlinelibrary.wiley.com/doi/pdfdirect/10.1002/aenm.202200015.

Les défis du CEA, février 2019, N°234.

**Revendications**

1. Procédé de traitement d'une plaquette de silicium cristallin comprenant du bore et de l'oxygène interstitiel formant des défauts qui augmentent la sensibilité à l'illumination de la plaquette de silicium cristallin, nommés défauts Bore-Oxygène, ledit procédé de traitement conduisant à une réduction de la densité desdits défauts Bore-Oxygène, qui comprend une étape i) de chauffage de la plaquette de silicium cristallin à une température appartenant à la gamme allant de 650°C à 1200°C, **caractérisé en ce que** l'étape i) est suivie d'une étape ii) de refroidissement ultra-rapide qui démarre alors que la plaquette de silicium cristallin est encore à une température de 600°C au moins, et, lors de laquelle, la température de la plaquette de silicium cristallin est abaissée selon une vitesse de refroidissement qui appartient à la gamme allant de 150 à 2000 °C/s, jusqu'à atteindre une température de 400°C ou moins, de préférence jusqu'à atteindre une température de 300°C ou moins.

2. Procédé de traitement selon la revendication 1, **caractérisé en ce qu'**il comprend en amont de l'étape i), une préparation préalable de la surface de la plaquette de silicium cristallin permettant de réduire les risques de contamination de la plaquette par des impuretés, lors de l'étape i) et/ou ii).

3. Procédé de traitement selon la revendication 1 ou 2, **caractérisé en ce qu'**il comprend en amont de l'étape i), une préparation préalable de la surface de la plaquette de silicium cristallin, ladite préparation comprenant ou consistant en une étape de texturation de la surface de la plaquette de silicium cristallin et/ou une étape de retrait d'une zone écrouie présente en surface de la plaquette de silicium cristallin et/ou une étape de formation en surface de la plaquette de silicium cristallin d'une couche jouant le rôle de couche barrière ou d'une couche développant un effet getter.

4. Procédé de traitement selon la revendication 1 ou 2, **caractérisé en ce qu'**il comprend en amont de l'étape i), une préparation préalable de la surface de la plaquette de silicium cristallin, ladite préparation comprenant ou consistant en une étape de texturation de la surface de la plaquette de silicium cristallin et/ou une étape de retrait d'une zone écrouie présente en surface de la plaquette de silicium cristallin et, lors de l'étape i), la formation en surface de la plaquette de silicium cristallin d'une couche jouant le rôle de couche barrière ou d'une couche développant un effet getter est réalisée.

5. Procédé de traitement selon l'une quelconque des revendications précédentes **caractérisé en ce que** les étapes i) et ii) sont réalisées dans les conditions de température suivantes :

- lors de l'étape i), le chauffage de la plaquette de silicium cristallin est réalisé à une température appartenant à la gamme allant de 700°C à 1050°C,
- lors de l'étape ii), le refroidissement ultra-rapide démarre alors que la plaquette de silicium cristallin est encore à une température de 600 °C au moins et la plaquette de silicium cristallin est abaissée selon une vitesse de refroidissement qui appartient à la gamme allant de 150 à 2000 °C/s, jusqu'à atteindre une température de 400°C ou moins, de préférence jusqu'à atteindre une température de 300°C ou moins.

6. Procédé de traitement selon l'une quelconque des revendications 1 à 4, **caractérisé en ce que** lors de l'étape i) la plaquette de silicium cristallin est chauffée à une température appartenant à la gamme allant de 650°C à 1200°C, de préférence à la gamme allant de 700°C à 1050°C, et typiquement à environ 1000°C, pendant une durée de 0,5 s à 120 min, de préférence pendant une durée de 1 s à 30 min.

7. Procédé de traitement selon l'une quelconque des revendications précédentes, **caractérisé en ce que** lors de l'étape ii), le refroidissement ultra-rapide est réalisé par immersion, dans de l'azote liquide, de la plaquette de silicium cristallin.

8. Procédé de traitement selon l'une quelconque des revendications précédentes, **caractérisé en ce que** le silicium cristallin est du silicium de type n ou du silicium de type p, notamment du silicium de type n compensé au bore.

9. Procédé de traitement selon l'une quelconque des revendications précédentes, **caractérisé en ce que** le silicium cristallin est du silicium Cz, en particulier du silicium Cz de type n, notamment du silicium Cz de type n compensé au bore ou du silicium Cz de type n obtenu à partir de silicium recyclé ou de grade solaire.

10. Procédé de traitement selon l'une quelconque des revendications précédentes, **caractérisé en ce que** le silicium cristallin de la plaquette de silicium cristallin contient de $5.10^{13}$ à $5.10^{17}$ atomes/cm$^3$ de bore, préférentiellement de $10^{14}$ à $10^{17}$ atomes/cm$^3$ de bore, et encore plus préférentiellement de $10^{15}$ à $5.10^{16}$ atomes/cm$^3$ de bore et de $8.10^{16}$ à $2,2.10^{18}$ atomes/cm$^3$ d'oxygène interstitiel, préférentiellement de $2.10^{17}$ à $2,2.10^{18}$ atomes/cm$^3$ d'oxygène interstitiel, et encore plus préférentiellement de $2.10^{17}$ à $7.10^{17}$ atomes/cm$^3$ d'oxygène interstitiel.

11. Procédé de traitement selon l'une quelconque des revendications précédentes, **caractérisé en ce qu'**il conduit à une diminution d'au moins 85%, et préférentiellement à une diminution de 90% ou plus, de la densité de défauts « Bore-Oxygène ».

12. Procédé de fabrication d'une cellule photovoltaïque, et en particulier d'une cellule photovoltaïque à hétérojonction, comprenant une étape consistant en la mise en œuvre du procédé selon l'une quelconque des revendications 1 à 11 conduisant à une plaquette de silicium cristallin Pt.

13. Procédé de fabrication selon la revendication 12, **caractérisé en ce qu'**il comprend une étape d'association de la plaquette de silicium cristallin Pt à au moins une couche semi-conductrice.

**14.** Procédé de fabrication selon la revendication 12 ou 13, **caractérisé en ce qu'**il ne comprend aucune étape de chauffage à une température de chauffage supérieure à 300°C mise en œuvre sur la plaquette de silicium cristallin Pt, après la mise en œuvre du procédé selon l'une quelconque des revendications 1 à 11, et, de préférence, il ne comprend aucune étape de chauffage mise en œuvre sur la plaquette de silicium cristallin Pt à une température de chauffage supérieure à 250°C, après la mise en œuvre du procédé selon l'une quelconque des revendications 1 à 11.

[Fig. 1]

[Fig. 2]

[Fig. 3]

[Fig. 4]

[Fig. 5]

Europäisches
Patentamt

European
Patent Office

Office européen
des brevets

**RAPPORT DE RECHERCHE EUROPEENNE**

Numéro de la demande

EP 25 21 8431

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2013/102129 A1 (FALSTER ROBERT J [GB]; VORONKOV VLADIMIR V [IT] ET AL.) 25 avril 2013 (2013-04-25) * le document en entier * ----- | 1-14 | INV. H10F71/10 H10F71/00 |
| A | US 2012/260989 A1 (DELUCA JOHN P [US]) 18 octobre 2012 (2012-10-18) * le document en entier * ----- | 1-14 | |

DOMAINES TECHNIQUES RECHERCHES (IPC)

H10F
H01F

Le présent rapport a été établi pour toutes les revendications

| Lieu de la recherche | Date d'achèvement de la recherche | Examinateur |
|---|---|---|
| Berlin | 23 mars 2026 | Voignier, Vincent |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.....................................................................................
& : membre de la même famille, document correspondant

EPO FORM 1503 03.82 (P04C02)

# EP 4 753 408 A1

## ANNEXE AU RAPPORT DE RECHERCHE EUROPEENNE
## RELATIF A LA DEMANDE DE BREVET EUROPEEN NO.

EP 25 21 8431

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-03-2026

| Document brevet cité au rapport de recherche | Date de publication | Membre(s) de la famille de brevet(s) | Date de publication |
|---|---|---|---|
| US 2013102129 A1 | 25-04-2013 | CN 103582955 A | 12-02-2014 |
| | | EP 2715805 A1 | 09-04-2014 |
| | | JP 6113152 B2 | 12-04-2017 |
| | | JP 2014526135 A | 02-10-2014 |
| | | KR 20140041614 A | 04-04-2014 |
| | | MY 181635 A | 30-12-2020 |
| | | SG 194904 A1 | 30-12-2013 |
| | | US 2013102129 A1 | 25-04-2013 |
| | | US 2015123248 A1 | 07-05-2015 |
| | | WO 2012167104 A1 | 06-12-2012 |
| US 2012260989 A1 | 18-10-2012 | AUCUN | |

Pour tout renseignement concernant cette annexe : voir Journal Officiel de l'Office européen des brevets, No.12/82

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **L.J. CABALLERO et al.** Influence of Pgettering thermal step on light-induced degradation. *Cz Si, Solar Energy Materials & Solar Cells*, 2005, vol. 88, 247-256
- Effective reduction of the metastable defect concentration in boron-doped Czochralski silicon for solar cells. **K. BOTHE et al.** Proceedings of Conf. Rec. Twenty-Ninth IEEE Photovolt. Spec. Conference. IEEE, 2003, 194-197
- **S. W. GLUNZ et al.** Minority carrier lifetime degradation in boron-doped Czochralski silicon. *J. Appl. Phys.*, 01 September 2001, vol. 90 (5)
- **S. W. GLUNZ et al.** Degradation of carrier lifetime in Cz silicon solar cells. *Sol. Energy Mater. Sol. Cells*, 2001, vol. 65, 219-229
- **N. NAMPALLI et al.** Multiple pathways for permanent deactivation of boron-oxygen defects in p-type silicon. *Solar Energy Materials and Solar Cells*, 2017, vol. 173, 12-17
- **F.E. ROUGIEUX et al.** Influence of net doping, excess carrier density and annealing on the boron oxygen related defect density in compensated n-type silicon. *J. Appl. Phys.*, 2011, vol. 110, 063708

- **H. WAGNER et al.** Optimizing phosphorus diffusion for photovoltaic applications: Peak doping, inactive phosphorus, gettering, and contact formation. *J. Appl. Phys.*, 2016, vol. 119, 185704, https://doi.org/10.1063/1.4949326
- **D.C. WALTER et al.** Effect of rapid thermal annealing on recombination centers in boron-doped Czochralski-grown silicon. *Appl. Phys. Lett.*, 2014, vol. 104, 42111, https://dx.doi.org/10.1063/1.4863674
- **Z.Y. YEO et al.** Status review and future perspectives on mitigating light-induced degradation on silicon-based solar cells. *Solar Energy Materials & Solar Cells*, 2014, vol. 131, 51-57
- **S. ZHAOKING et al.** Toward Efficiency Limits of Crystalline Silicon Solar Cells: Recent Progress in High-Efficiency Silicon Heterojunction Solar Cells. *Advanced Energy Materials*, 2022, vol. 12 (23), 2200015, https://onlinelibrary.wiley.com/doi/pdfdirect/10.1002/aenm.202200015
- *Les défis du CEA*, February 2019 (234)